# EUROPEAN PATENT SPECIFICATION

(11) **EP 2 958 198 B1**
(45) Date of publication and mention of the grant of the patent: **21.02.2018**
(21) Application number: 13875271.2
(22) Date of filing: 09.12.2013
(51) Int. Cl.: H01R 13/66, H01R 13/641, H05K 5/03, H01R 13/506, H01R 24/76, H02G 3/08, H02G 3/14

(54) **WIRING DEVICE COMPRISING A PRINTED WIRING BOARD AND A HOUSING**
VERKABELUNGSVORRICHTUNG MIT EINEM GEHÄUSE UND EINER LEITERPLATTE
DISPOSITIF DE CÂBLAGE COMPRENANT UN BOÎTIER ET UN CIRCUIT IMPRIMÉ

(30) Priority: 13.02.2013 JP 2013025257
(43) Date of publication of application: 23.12.2015
(73) Proprietor: Panasonic Intellectual Property Management Co., Ltd., Osaka-shi, Osaka 540-6207 (JP)
(72) Inventor: HIRATA, Satoshi, Osaka 540-6207 (JP); MATSUURA, Shuji, Osaka 540-6207 (JP); LO, Chihwei, Tah Si Toa Yuan (TW); CHIEN, Chiungyu, Tah Si Toa Yuan (TW)
(74) Representative: Appelt, Christian W.
(86) International application number: PCT/JP2013/007235
(87) International publication number: WO 2014/125540

(56) References cited:
- CN-Y- 201 252 144
- JP-A- H1 116 684
- JP-A- 2004 220 814
- JP-A- 2008 171 837
- JP-U- 3 172 236
- US-A1- 2004 043 647
- US-A1- 2013 267 116

## Description

### TECHNICAL FIELD

The invention relates to a wiring device.

### BACKGROUND ART

Conventionally, there has been a USB (Universal Serial Bus) outlet that has a USB socket to which a USB plug is inserted and connected (see JP 2011-82802 A). This type of USB outlet includes: a printed wiring board on which the above-mentioned USB socket is mounted; and a housing that has a plug insertion hole into which the above-mentioned USB plug is inserted, and houses the printed wiring board.

There has been also a wiring device that include the printed wiring board and the housing, as the above-mentioned USB outlet, and further the housing includes a cover and a body that are coupled with each other while the printed wiring board is held therebetween in a thickness direction of the printed wiring board.

For example, in a case where the cover has twofold symmetrical shape with respect to an axis parallel to the thickness direction of the printed wiring board, there is a possibility that the cover is attached to the body in the opposite direction that is turned by 180 degrees from a correct direction around the above-mentioned axis, when assembling the wiring device.

Document CN 201 252 144 Y discloses a USB charger, which comprises a USB data wire and a charging interface, wherein an interface needle position is arranged in the charging interface and a needle position adjusting mechanism is connected between the USB data wire and the interface needle position of the charging interface.

US 2004/0043647 A1 shows an electric distribution box that includes a distribution box body in which interior parts are mounted and a cover attached to the distribution box body to protect the interior parts. The cover is completely fixed to the distribution box body in a first position. The cover is provisionally fixed to the distribution box body in a second position different from the first position.

US 2013/0267116 A1 relates to a wall outlet type USB hub with independent charging function includes a mounting case and a combined USB hub and socket unit. The mounting case includes a rear case portion for mounting on a wall and a front case portion assembled to a front opening of the rear case portion. The combined USB hub and socket unit includes a housing member held in the mounting case via retaining means and having multiple openings; a printed circuit board located inside the housing member and having a power module and a hub module; multiple data transfer ports electrically connected to the hub module and aligned with the openings on the housing member; and a power connector electrically connected to the power module. The wall outlet type USB hub matches general wall outlet's cover plate specification and can replace existing AC wall outlet to enable both data transmission and DC power supply functions.

JP 2008/171837 A provides a substrate supporting structure of an electronic apparatus which performs sorting and discarding of plastic products and circuit boards easily by making it possible to fix a plurality of circuit boards in a case while positioning and to separate them by opening/closing the case using one screw.

### DISCLOSURE OF THE INVENTION

It is an object of the present invention to provide a wiring device, which can prevent incorrect assembly. The object is solved by the subject matter of independent claim 1. Advantageous embodiments are subject to the dependent claims.

A wiring device inter alia includes: a printed wiring board; and a housing for housing the printed wiring board. The housing includes a body and a cover that are coupled with each other while the printed wiring board is held therebetween in a thickness direction of the printed wiring board. The body and the cover have engagement parts that are engaged with each other. At least parts of the engagement parts are configured not to be engaged with each other in a state where the cover is turned by 180 degrees from a correct assembling direction around an axis parallel to the thickness direction of the printed wiring board.

Preferably, the wiring device further includes a USB socket that is mounted on the printed wiring board.

According to the present invention, because at least parts of the engagement parts cannot be engaged with each other even when the cover is sought to be attached to the body in an incorrect direction that is turned by 180 degrees from a correct assembling direction around an axis parallel to the thickness direction of the printed wiring board, it is possible to prevent the wiring device from being assembled in the incorrect direction as above.

### BRIEF DESCRIPTION OF THE DRAWINGS

Preferred embodiments of the invention will now be described in further details. Other features and advantages of the present invention will become better understood with regard to the following detailed description and accompanying drawings where:
Figs. 1A and 1B are perspective views partly broken away at different positions, when viewed from mutually opposite directions, illustrating a wiring device according to an embodiment of the present invention;
Figs. 2A and 2B are exploded perspective views partly broken away at different positions, when viewed from mutually opposite directions, illustrating the wiring device according to the embodiment of the present invention;
Fig. 3 is a cross-section view illustrating the wiring device according to the embodiment of the present invention;
Fig. 4 is an exploded perspective view illustrating the wiring device, in a state where a second printed wiring board has been installed in a body, according to the embodiment of the present invention;
Fig. 5 is an exploded perspective view illustrating the wiring device according to the embodiment of the present invention;
Fig. 6 is a perspective view illustrating the wiring device according to the embodiment of the present invention;
Fig. 7 is an exploded perspective view partly broken away, illustrating the wiring device according to the embodiment of the present invention;
Fig. 8 is a perspective view illustrating the wiring device, to which a mounting frame has been attached, according to the embodiment of the present invention;
Fig. 9 is an exploded perspective view illustrating the wiring device and the mounting frame according to the embodiment of the present invention;
Fig. 10 is a plane view illustrating the body of the wiring device according to the embodiment of the present invention; and
Fig. 11 is a bottom view illustrating a cover of the wiring device according to the embodiment of the present invention.

### BEST MODE FOR CARRYING OUT THE INVENTION

Hereinafter, best mode for carrying out the present invention will be explained, referring to Figures.

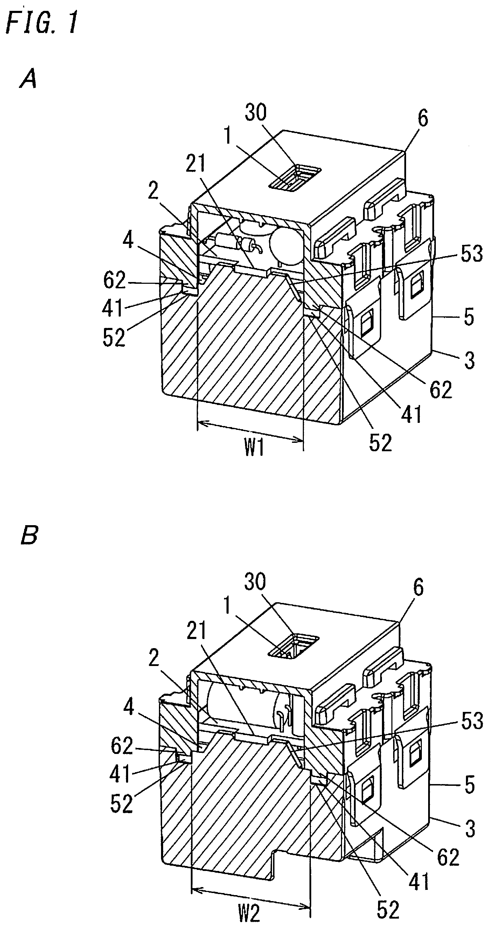

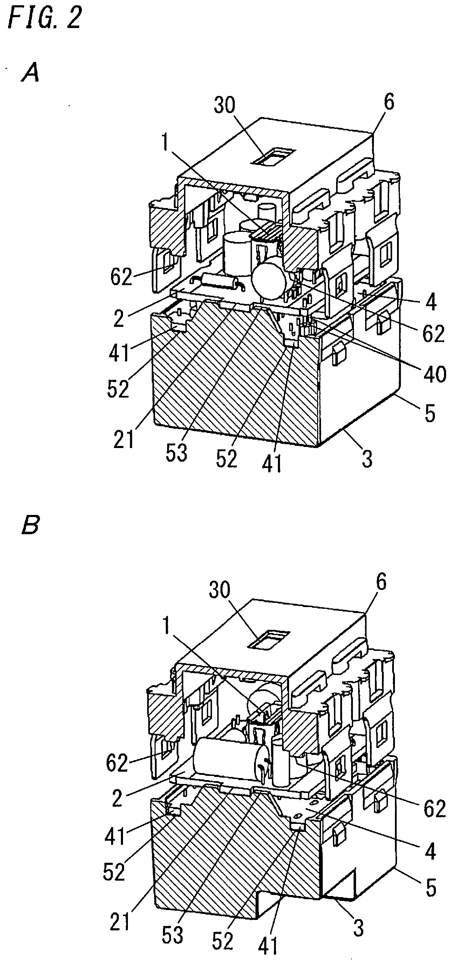

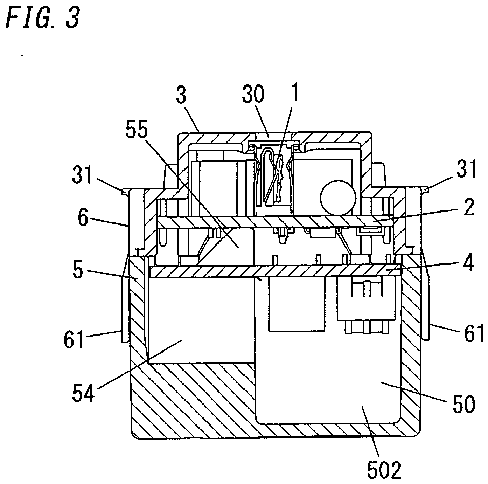

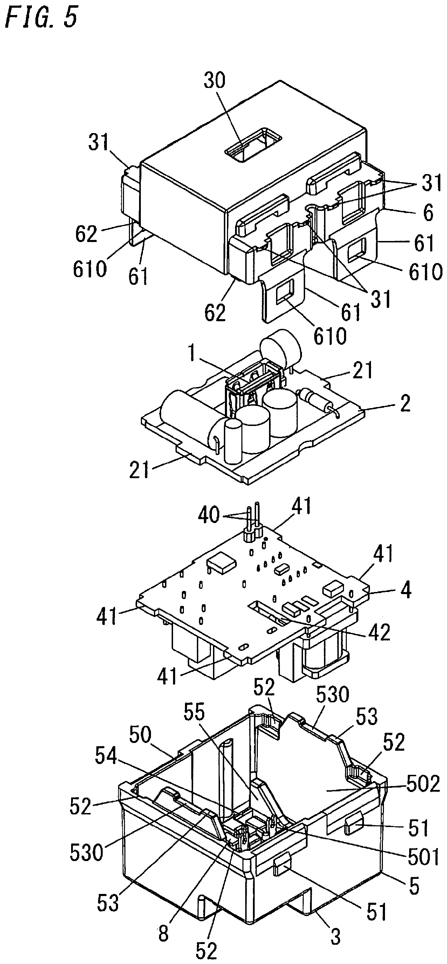

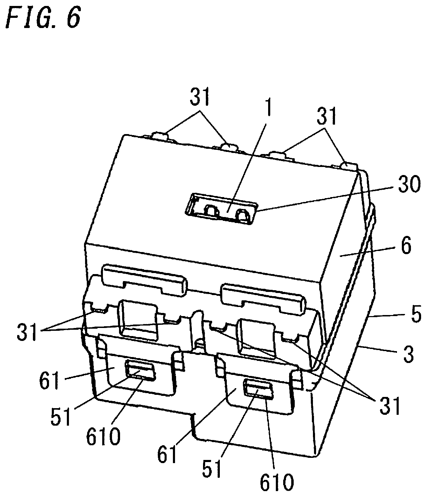

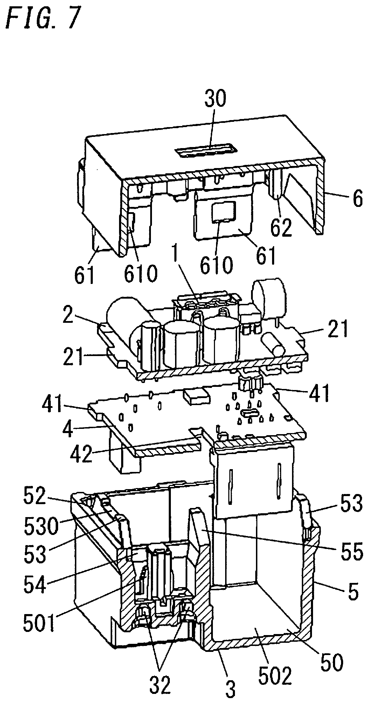

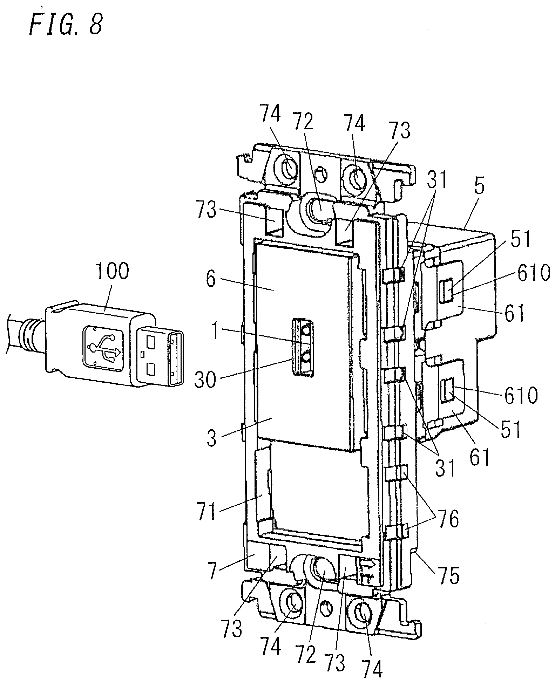

As shown in Figs. 1A to 9, a wiring device according to the present embodiment includes a printed wiring board **2** (hereinafter, called "a first printed wiring board") on which a USB socket **1** is mounted, and a housing **3** for housing the printed wiring board **2.** As shown in Fig. 8, the housing **3** has a plug insertion hole **30** in which a USB plug **100** is inserted to be connected to the USB socket **1.** The USB socket **1** is mounted on the first printed wiring board **2** while a direction in which the USB plug **100** is inserted in or removed from the USB socket **1** faces a thickness direction of the first printed wiring board **2.**

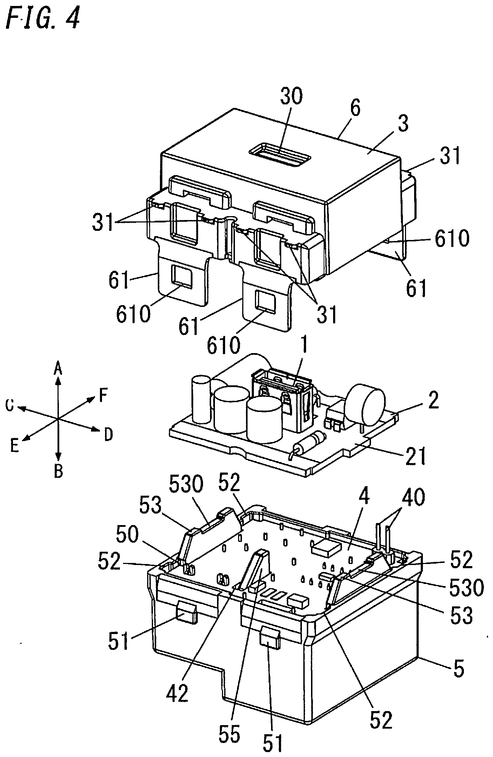

Hereinafter, **A, B, C, D, E** and **F** directions shown in Fig. 4 are called upper, lower, left, right, front and back directions, respectively. That is, the USB socket **1** has an opening into which the USB plug **100** is inserted, and a direction (the **A** direction in Fig. 4) in which the opening is directed is called the upper direction. Here, a direction parallel to the direction in which the opening is directed is defined as a First direction. A longitudinal direction (which is a longitudinal direction when viewed from the upper direction, and is a **D-C** direction in Fig. 4) of the USB socket **1** is called a right-left direction. Here, the longitudinal direction of the USB socket **1** when viewed from the First direction is defined as a Second direction. A lateral direction (which is a lateral direction when viewed from the upper direction, and is an **E-F** direction in Fig. 4) of the USB socket **1** is called a front-back direction. Here, a direction perpendicular to the First and Second directions is defined as a Third direction. The above-mentioned directions are defined only for convenience of explanations, and therefore, although in Fig. 4 the First direction is directed in a vertical direction, the First direction may be directed in a horizontal direction when the wiring device is in a normal use situation, as shown in Fig. 8 for example.

Further, the wiring device according to the present embodiment includes an AC-DC converter that converts AC power inputted from an external AC source into DC power having a predetermined voltage and outputs the converted DC power to the USB plug **100** through the USB socket **1.** Because the above-mentioned AC-DC converter can be implemented by well-known arts, detail illustrations and explanations thereof are omitted. Circuit components that constitute the above-mentioned AC-DC converter are separately mounted on the first printed wiring board **2,** and a second printed wiring board **4** that is held by the housing **3** while being housed in the housing **3** so as to be opposed to the lower side of the first printed wiring board **2.** The first and second printed wiring boards **2, 4** are electrically connected to each other through a suitable conduction path **40,** such as current-carrying pins.

The housing **3** includes a body **5** and a cover **6** that are coupled with each other while the first and second printed wiring boards **2, 4** are held between the body and cover in thickness directions of the first and second printed wiring boards (the upper-lower direction, namely the First direction).

The body **5** is formed into a box shape, of which an upper end side is opened, and has front and rear end faces, each of which is provided with two connecting projections **51** that are arranged in the right-left direction (the Second direction) and project outward along the front-back direction (the Third direction). The cover **6** is formed into a box shape, of which a lower end side is opened, and has front and rear end portions, each of which is provided with two connecting pieces **61** that project downward. Then, those four connecting pieces **61** hold the body **5** in the front-back direction (the Third direction). Each connecting piece **61** is provided with a connecting hole **610** that is a through-hole penetrating in the front-back direction (the Third direction). The connecting projections **51** are respectively inserted into and engaged with the connecting holes **610,** and thereby the body **5** and the cover **6** are coupled with each other.

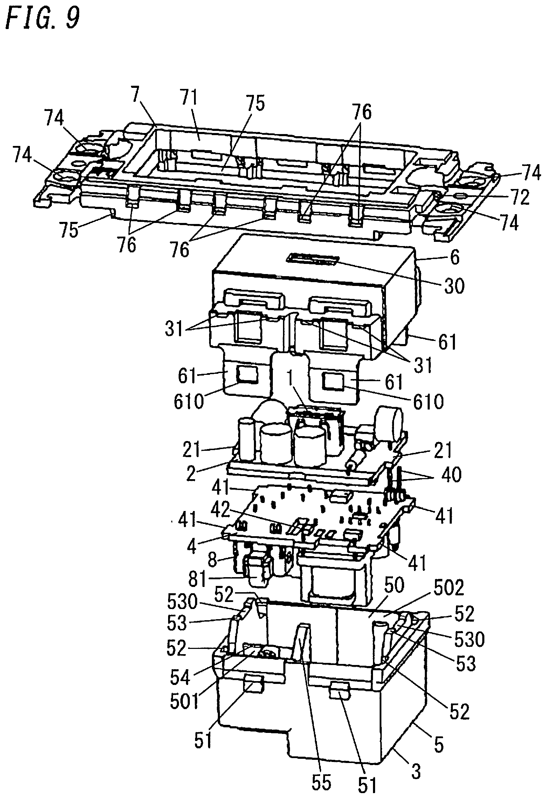

The housing **3** is fixed at a surface to be worked (not shown), such as a wall surface, with a mounting frame **7** shown in Figs. 8 and 9. The mounting frame **7** is formed into a rectangular frame shape, and has a rectangular window hole **71.** In the longitudinal direction of the window hole **71,** the mounting frame **7** has both end portions, each of which is provided with a box hole **72** that is formed into a rectangle shape having rounded corners. The box hole **72** is provided for inserting a box screw that is screwed in an embedded box embedded in the surface to be worked. Further, each of said both end portions is provided with two hook holes **73** that are arranged across one box hole **72** in the lateral direction of the window hole **71** when viewed from the First direction. Each hook hole **73** is provided as a through-hole along the First direction. In a case where the surface to be worked is formed of a panel material, holding fittings (not shown) are respectively hooked in and engaged with the hook holes **73,** in order to hold the panel material between the mounting frame **7** and the holding metal fittings. Further, the mounting frame **7** is provided with four circle-shaped direct mounting holes **74,** as through-holes along the First direction. Specifically, each direct mounting hole **74** is located so as to be opposed to the window hole **71** across one hook hole **73** when viewed from the First direction. Then, in a case where the mounting frame **7** is mounted directly on the surface to be worked, four direct mounting screws that are screwed in the surface to be worked are respectively inserted into the four direct mounting holes **74.** The mounting frame **7** is further provided with two holding pieces **75** that are respectively located at both end edges of the window hole **71** in the lateral direction, and project backward. Each holding piece **75** is provided with three pairs of mounting holes **76** that are arranged in the longitudinal direction. The housing **3** is provided at each of front and rear surfaces thereof with two pairs of mounting projections **31** that are configured to be inserted into and engaged with two pairs of said three pairs of mounting holes **76.** That is, each mounting projection **31** is inserted into and engaged with the corresponding mounting hole **76,** and thereby, the housing **3** is coupled with the mounting frame **7.**

The body **5** is provide with a housing recess **50** of which the upper side is opened, and the second printed wiring board **4** is housed in the housing recess **50.**

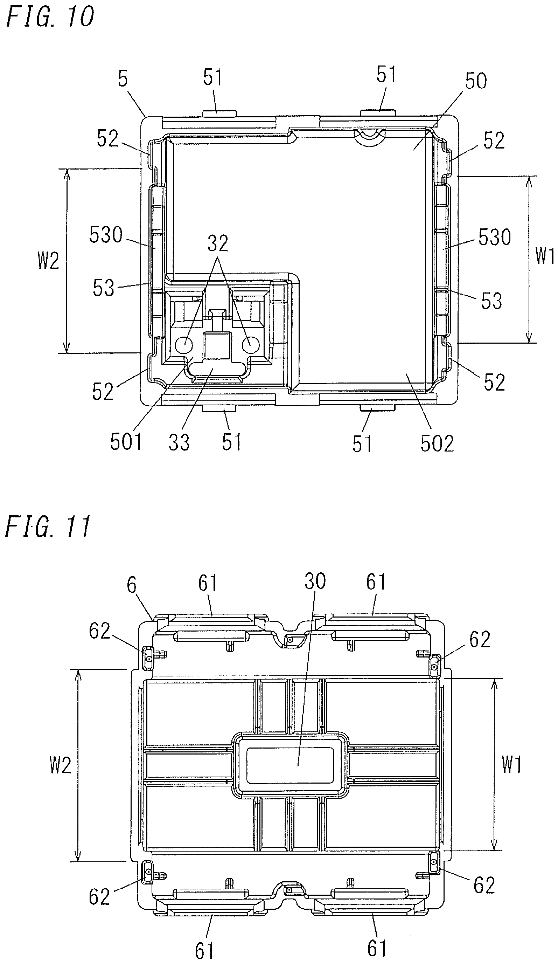

Further, the body **5** is provided at a lower surface thereof with two electric wire insertion holes **32.** Then, a terminal 8 is mounted on a lower surface of the second printed wiring board **4,** and electric wires (not shown) that are inserted through the electric wire insertion holes **32** are connected to the terminal **8.** The terminal **8** is a so-called quick connection terminal that has two locking springs (not shown) provided for locking the electric wires inserted through the electric wire insertion holes **32.** The two locking springs correspond to the electric wire insertion holes **32** one-to-one. Further, the terminal **8** has a release button **81** that is configured to release the lock by pressing each locking spring when pressed from below. The body **5** is further provided at the lower surface thereof with a release hole **33** (see Fig. 10) that exposes the release button **81** downward. Then, a tool (not shown), such as a slotted screw driver, is inserted into the release hole **33,** and thereby, operation for pressing the release button **81** can be performed.

The body **5** is further provided with a partition wall **54** that is formed so as to partition the housing recess **50** into: a terminal housing section **501** that houses the terminal **8;** and a circuit housing section **502** that houses other circuit components. Each electric wire insertion hole **32** and each release hole **33** are opened at a bottom surface of the terminal housing section **501.**

Further, the partition wall **54** is provided at an upper end thereof with an abutting part **55** that is inserted to a through-hole **42** formed at the second printed wiring board **4** and then abuts to a central part (that is, near the USB socket **1**) of the lower surface of the first printed wiring board **2.**

Further, the body **5** includes two supporting projections **53** that: are located at right and left ends of the body **5** respectively; project upward; and support the first printed wiring board **2** (that is, that abut to the lower surface of the board **2** that is an opposite surface of one surface of the board **2** on which the USB socket **1** is mounted). Each supporting projection **53** is provided at an upper end thereof with a supporting recess **530** that is opened in the right-left direction (the Second direction). On the other hand, the first printed wiring board **2** is provided at each of right and left ends thereof with a leg part **21** that projects outward in the right-left direction (the Second direction). The USB socket **1** lies between the two leg parts **21** in the longitudinal direction (the right-left direction, namely, the Second direction) when viewed from above. Each leg part **21** is housed in the corresponding supporting recess **530,** and thereby, it is possible to prevent a positional displacement of the first printed wiring board **2** in the front-back direction (the Third direction) or the lower direction (one side of the First direction). In other words, the first printed wiring board **2** is supported by the supporting projections **53** of the body **5** through the leg parts **21.**

Further, the body **5** has engagement parts. Specifically, as shown in Figs. 1, 2 and 10, the body **5** is provided with, as the engagement parts, four engagement recesses **52** in total that are opened upward. Two of the four engagement recesses **52** are formed at one of upper ends of right and left inner surfaces of the housing recess **50** that are opposed to each other in the right-left direction (the Second direction). The remaining two engagement recesses **52** are formed at the other of said upper ends. On the other hand, the second printed wiring board **4** is provided with four engagement projections **41** in total that are capable of being engaged with the four engagement recesses **52** respectively. Two of the four engagement projections **41** are arranged in the front-back direction (the Third direction) at a right end of the second printed wiring board **4,** and project in the right direction. The remaining two engagement projections **41** are arranged in the front-back direction (the Third direction) at a left end of the second printed wiring board **4,** and project in the left direction. Then, each engagement projection **41** abuts to an inner surface of the corresponding engagement recess **52,** and thereby, it is possible to prevent a positional displacement of the second printed wiring board **4** in the lower direction (one side of the First direction) or the front-back direction (the Third direction). In other words, the second printed wiring board **4** is supported by the body **5** through the engagement projections **41.**

Further, the cover **6** has engagement parts. Specifically, as shown in Figs. 1, 2 and 11, the cover **6** is provided with, as the engagement parts, four engagement projections **62** in total that project downward. Two of the four engagement projections **62** are arranged in the front-back direction (the Third direction) at a right end of the cover **6,** and are configured to be capable of being inserted into the two engagement recesses **52** located at the right end of the body **5** respectively. The remaining two engagement projections **62** are arranged in the front-back direction (the Third direction) at a left end of the cover **6,** and are configured to be capable of being inserted into the two engagement recesses **52** located at the left end of the body **5** respectively. The four engagement projections **41** of the second printed wiring board **4** are held between the four engagement projection **62** of the cover **6** and upward inner surfaces of the four engagement recess **52,** respectively.

Here, a distance **W1** between the two engagement recesses **52** at the right side of the body **5** is configured so as to be smaller than a distance **W2** between the two engagement recesses **52** at the left side of the body **5.** A distance between the two engagement projections **62** at the right side of the cover **6** is configured so as to be substantially equal to the distance **W1** between the two engagement recesses **52** at the right side of the body **5.** A distance between the two engagement projections **62** at the left side of the cover **6** is configured so as to be substantially equal to the distance **W2** between the two engagement recesses **52** at the left side of the body **5.**

According to the above-mentioned configuration, even if a worker seeks to attach the second printed wiring board **4** or the cover **6** to the body **5** in an incorrect direction that is turned by 180 degrees from a correct direction around an axis parallel to the upper-lower direction (the First direction, namely, the thickness direction of the second printed wiring board **4**) upon assembling the wiring device, the worker cannot engage the engagement projections **41, 62** with engagement recesses **52.** Therefore, it is possible to prevent incorrect assembly, such as attaching the cover **6** or the second printed wiring board **4** to the body **5** in the incorrect direction as above.

Here, a sign (not shown) may be attached to the cover **6.** As a method for attaching the sign, a well-known method, such as printing, forming concavity and convexity, or putting a seal, can be adopted. As information provided by the sign, for example, an attaching direction (an upper-lower direction) to the mounting frame **7** or a manufacturer is cited. In the present embodiment, it is possible to prevent incorrect assembly as above, and therefore, it is possible to keep constant a positional relationship or a relationship of a direction between the sign and the electric wire insertion hole **32** or the USB socket **1.**

The projections and recesses of the engagement parts may be reversed to the above-mentioned configuration. That is, the body **5** may be provided with engagement projections, and the cover **6** may be provided with engagement recesses which the engagement projections of the body **5** are inserted into and engaged with.

The locations of the engagement recesses **52** and the engagement projections **41, 62** are not limited to the above-mentioned locations, as long as those locations are dissymmetry with respect to an axis parallel to the upper-lower direction (the First direction, namely, the thickness direction of the first printed wiring board **2**).

As explained above, the wiring device according to the present embodiment includes: a printed wiring board (the first printed wiring board **2**); and the housing **3** for housing the printed wiring board (the first printed wiring board **2**). The housing **3** includes the body **5** and the cover **6** that are coupled with each other while the printed wiring board (the first printed wiring board **2**) is held therebetween in a thickness direction of the printed wiring board (the first printed wiring board **2**). The body **5** and the cover **6** have engagement parts (the engagement recesses **52** and the engagement projections **62**) that are engaged with each other. At least parts of the engagement parts (the engagement recesses **52** and the engagement projections **62**) are configured not to be engaged with each other in a state where the cover **6** is turned by 180 degrees from a correct assembling direction around an axis parallel to the thickness direction of the printed wiring board (the first printed wiring board **2**). Preferably, the wiring device according to the present embodiment further includes the USB socket **1** that is mounted on the printed wiring board (the first printed wiring board **2**).

Although the present invention has been described with reference to certain preferred embodiments, numerous modifications and variations can be made by those skilled in the art without departing from the scope of this invention, namely claims.

## Claims

1. A wiring device, comprising:
a printed wiring board (4); and
a housing (3) for housing the printed wiring board (4),
wherein the housing (3) comprises a body (5) and a cover (6) that are coupled with each other while the printed wiring board (4) is held therebetween in a thickness direction of the printed wiring board (4),
wherein the body (5) and the cover (6) have engagement parts that are engaged with each other, and
wherein at least parts of the engagement parts are configured not to be engaged with each other in a state where the cover is turned by 180 degrees from a correct assembling direction around an axis parallel to the thickness direction of the printed wiring board (4)
wherein the body (5) is provided with, as a part of the engagement parts, an engagement recess (52) that is opened upward,
wherein the cover (6) is provided with, as a part of the engagement parts, an engagement projection (62) that projects downward and is configured to be capable of being inserted into the engagement recess (52) of the body (5),
**characterized in that**
the printed wiring board (4) is provided with an engagement projection (41) that is capable of being engaged with the engagement recess (52),
wherein the engagement projection (41) of the printed wiring board (4) is configured to be held between the engagement projection (62) of the cover (6) and an upward inner surface of the engagement recess (52).

2. The wiring device according to claim 1, further comprising:
another printed wiring board (2) that is disposed to face said printed wiring board (4) that is the printed wiring board (4); and
a USB socket (1) that is mounted on the other printed wiring board (2).

3. The wiring device according to claim 1 or 2, wherein:
the body (5) comprises four engagement recesses (52),
the cover (6) comprises four engagement projections (62), and
the printed wiring board (4) comprises four engagement projections (41);
wherein the four engagement projections (41) of the printed wiring board (4) are configured to be respectively held between the four engagement projections (62) of the cover (6) and upward inner surfaces of the four engagement recesses (52).

4. The wiring device according to claim 3, wherein:
a distance (W1) between two engagement recesses (52) at one side, of the four engagement recesses (52) of the body (5) is configured so as to be smaller than a distance (W2) between two engagement recesses (52) at the other side, of the four engagement recesses (52) of the body (5),
a distance between two engagement projections (62) at one side, of the four engagement projections (62) of the cover (6) is configured so as to be substantially equal to the distance (W1) between the two engagement recesses (52) at the one side of the body (5), and
a distance between two engagement projections (62) at the other side, of the four engagement projections (62) of the cover (6) is configured so as to be substantially equal to the distance (W2) between the two engagement recesses (52) at the other side of the body (5).

## Patentansprüche

1. Verkabelungsvorrichtung mit:
einer Leiterplatte (4); und
einem Gehäuse (3) zur Aufnahme der Leiterplatte (4),
wobei das Gehäuse (3) einen Körper (5) und eine Abdeckung (6) aufweist, die miteinander verbunden sind, während die Leiterplatte (4) in einer Dickerichtung der Leiterplatte (4) dazwischen gehalten wird,
wobei der Körper (5) und die Abdeckung (6) Eingriffsteile haben, die miteinander in Eingriff stehen, und
wobei wenigstens Teile der Eingriffsteile dafür ausgelegt sind, in einem Zustand, in dem die Abdeckung um eine Achse parallel zu der Dickerichtung der Leiterplatte (4) von einer Einbaurichtung aus um 180 Grad gedreht ist, nicht miteinander in Eingriff zu kommen,
wobei der Körper (5) als ein Teil der Eingriffsteile mit einer Eingriffsausnehmung (52) ausgebildet ist, die nach oben hin geöffnet ist,
wobei die Abdeckung (6) als ein Teil der Eingriffsteile mit einem Eingriffsvorsprung (62) versehen ist, der nach unten vorragt und dafür ausgelegt ist, sich in die Eingriffsausnehmung (52) des Körpers (5) einsetzen zu lassen,
**dadurch gekennzeichnet, dass**
die Leiterplatte (4) mit einem Eingriffsvorsprung (41) versehen ist, der sich mit der Eingriffsausnehmung (52) in Eingriff bringen lässt,
wobei der Eingriffsvorsprung (41) der Leiterplatte (4) dazu eingerichtet ist, zwischen dem Eingriffsvorsprung (62) der Abdeckung (6) und einer oberen Innenfläche der Eingriffsausnehmung (52) gehalten zu werden.

2. Verkabelungsvorrichtung nach Anspruch 1, ferner aufweisend:
eine weitere Leiterplatte (2), die angeordnet ist, um besagter Leiterplatte (4), die die Leiterplatte (4) ist, zugewandt zu sein; und
eine USB-Buchse (1), die auf der weiteren Leiterplatte (2) eingebaut ist.

3. Verkabelungsvorrichtung nach Anspruch 1 oder 2, wobei:
der Körper (5) vier Eingriffsausnehmungen (52) aufweist,
die Abdeckung (6) vier Eingriffsvorsprünge (62) aufweist, und
die Leiterplatte (4) vier Eingriffsvorsprünge (41) aufweist;
wobei die vier Eingriffsvorsprünge (41) der Leiterplatte (4) dazu eingerichtet sind, zwischen den vier Eingriffsvorsprüngen (62) der Abdeckung (6) und oberen Innenflächen der vier Eingriffsausnehmungen (52) gehalten zu werden.

4. Verkabelungsvorrichtung nach Anspruch 3, wobei:
ein Abstand (W1) zwischen zwei Eingriffsausnehmungen (52) an einer Seite der vier Eingriffsausnehmungen (52) des Körpers (5) dafür ausgelegt ist, kleiner zu sein als ein Abstand (W2) zwischen zwei Eingriffsausnehmungen (52) an der anderen Seite der vier Eingriffsausnehmungen (52) des Körpers (5),
ein Abstand zwischen zwei Eingriffsvorsprüngen (62) an einer Seite der vier Eingriffsvorsprünge (62) der Abdeckung (6) dafür ausgelegt ist, im Wesentlichen gleich dem Abstand (W1) zwischen den beiden Eingriffsausnehmungen (52) an der einen Seite des Körpers (5) zu sein, und
ein Abstandswert zwischen zwei Eingriffsvorsprüngen (62) an der anderen Seite der vier Eingriffsvorsprünge (62) der Abdeckung (6) dafür ausgelegt ist, im Wesentlichen gleich dem Abstand (W2) zwischen den beiden Eingriffsausnehmungen (52) an der anderen Seite des Körpers (5) zu sein.

## Revendications

1. Dispositif de câblage, comprenant :
une carte de circuit imprimé (4) ; et
un boîtier (3) destiné à contenir la carte de circuit imprimé (4),
dans lequel le boîtier (3) comprend un corps (5) et un couvercle (6) qui sont reliés l'un à l'autre tandis que la carte de circuit imprimé (4) est maintenue entre eux dans une direction d'épaisseur de la carte de circuit imprimé (4),
dans lequel le corps (5) et le couvercle (6) possèdent des parties d'engagement engagées les unes avec les autres, et
dans lequel au moins des parties des parties d'engagement sont configurées pour ne pas être engagées les unes avec les autres lorsque le couvercle est tourné à 180 degrés par rapport à une direction d'assemblage correcte autour d'un axe parallèle à la direction d'épaisseur de la carte de circuit imprimé (4),
dans lequel le corps (5) est muni, en guise de partie des parties d'engagement, d'un renfoncement d'engagement (52) qui est ouvert vers le haut,
dans lequel le couvercle (6) est muni, en guise de partie des parties d'engagement, d'une saillie d'engagement (62) qui se projette vers le bas et est configurée pour pouvoir être insérée dans le renfoncement d'engagement (52) du corps (5),
**caractérisé en ce que**
la carte de circuit imprimé (4) est munie d'une saillie d'engagement (41) qui peut être engagée avec le renfoncement d'engagement (52),
dans lequel la saillie d'engagement (41) de la carte de circuit imprimé (4) est configurée pour être maintenue entre la saillie d'engagement (62) du couvercle (6) et une surface interne montante du renfoncement d'engagement (52).

2. Dispositif de câblage selon la revendication 1, comprenant en outre :
une autre carte de circuit imprimé (2) qui est disposée pour faire face à ladite carte de circuit imprimé (4) qui est la carte de circuit imprimé (4) ; et
une prise USB (1) qui est montée sur l'autre carte de circuit imprimé (2).

3. Dispositif de câblage selon les revendications 1 ou 2, dans lequel :
le corps (5) comprend quatre renfoncements d'engagement (52),
le couvercle (6) comprend quatre saillies d'engagement (62), et
la carte de circuit imprimé (4) comprend quatre saillies d'engagement (41) ;
dans lequel les quatre saillies d'engagement (41) de la carte de circuit imprimé (4) sont configurées pour être respectivement maintenues entre les quatre saillies d'engagement (62) du couvercle (6) et les surfaces internes montantes des quatre renfoncements d'engagement (52).

4. Dispositif de câblage selon la revendication 3, dans lequel :
une distance (W1) entre deux renfoncements d'engagement (52) d'un côté des quatre renfoncements d'engagement (52) du corps (5) est configurée de façon à être inférieure à une distance (W2) entre deux renfoncements d'engagement (52) au niveau de l'autre côté des quatre renfoncements d'engagement (52) du corps (5),
une distance entre deux saillies d'engagement (62) d'un côté des quatre saillies d'engagement (62) du couvercle (6) est configurée de façon à être sensiblement égale à la distance (W1) entre les deux renfoncements d'engagement (52) au niveau du côté du corps (5), et
une distance entre deux saillies d'engagement (62) de l'autre côté des quatre saillies d'engagement (62) du couvercle (6) est configurée de façon à être sensiblement égale à la distance (W2) entre les deux renfoncements d'engagement (52) au niveau de l'autre côté du corps (5).
